# EUROPEAN PATENT SPECIFICATION

(11) **EP 2 688 205 B1**
(45) Date of publication and mention of the grant of the patent: **02.11.2016**
(21) Application number: 12177121.6
(22) Date of filing: 19.07.2012
(51) Int. Cl.: H03G 3/30

(54) **Mobile device with selective wlan receive gain levels and related methods**
Mobile Vorrichtung mit selektiven WLAN-Empfangsverstärkungsstufen und zugehörige Verfahren
Dispositif mobile avec niveaux de gain de réception WLAN sélectifs et procédés associés

(43) Date of publication of application: 22.01.2014
(73) Proprietor: BlackBerry Limited, Waterloo, ON N2K 0A7 (CA)
(72) Inventor: He, Fei, Waterloo, Ontario N2L 3W8 (CA); Xu, Jun, Waterloo, Ontario N2L 3W8 (CA); Zhu, Lizhong, Waterloo, Ontario N2L 3W8 (CA)
(74) Representative: Hibbert, Juliet Jane Grace

(56) References cited:
- WO-A2-2004/075423
- US-A1- 2008 292 032
- US-A1- 2012 034 891

## Description

### Technical Field

The present invention relates to the field of communications, and, more particularly, to wireless communications and related methods.

### Background

Cellular communication systems continue to grow in popularity and have become an integral part of both personal and business communications. Cellular telephones allow users to place and receive phone calls almost anywhere they travel. Moreover, as cellular telephone technology is advanced, so too has the functionality of cellular devices. For example, many cellular devices now incorporate Personal Digital Assistant (PDA) features such as calendars, address books, task lists, calculators, memo and writing programs, etc. These multifunction devices usually allow users to wirelessly send and receive electronic mail (email) messages and access the internet via a cellular network and/or a wireless local area network (WLAN), for example.

Cellular devices have radio frequency (RF) processing circuits and receive or transmit radio communications signals typically using modulation schemes. The typical cellular device may have multiple transmit and receive pathways from the antenna to a digital signal processor (DSP). In particular, each signal pathway may comprise a filter to help isolate the desired frequency band from extraneous electromagnetic signals, for example, noise and interference.

Nevertheless, as frequency bands change because of regulatory reasons, expansion, etc. and as more transceivers are added to the cellular device, the likelihood of self-interference may increase. For example, the cellular transceiver may desensitize the wireless local area network (WLAN) transceiver during transmission periods, i.e. potentially rendering the WLAN transceiver inoperative.

### Brief Description of the Drawings

FIG. 1 is a schematic block diagram of an example embodiment of a mobile wireless communications device.
FIG. 2 is a detailed schematic block diagram of an example embodiment of the WLAN transceiver from the mobile wireless communications device of FIG. 1.
FIG. 3 is a flowchart illustrating operation of an example embodiment of the mobile wireless communications device of FIG. 1.
FIGS. 4-8 are charts illustrating performance of an example embodiment of a mobile wireless communications device.
FIG. 9 is a schematic block diagram illustrating example components of a mobile wireless communications device that may be used with the mobile wireless communications device of FIG. 1.

### Detailed Description

The present description is made with reference to the accompanying drawings, in which embodiments are shown. However, many different embodiments may be used, and thus the description should not be construed as limited to the embodiments set forth herein. Rather, these embodiments are provided so that this disclosure will be thorough and complete. Like numbers refer to like elements throughout.

The invention is defined by the appended claims. Generally speaking, a mobile wireless communications device may include a housing, a cellular transceiver carried by the housing and configured to operate at a given transmit power level from among a plurality different transmit power levels, and a WLAN transceiver carried by the housing and configured to operate at a given receive gain level from among a plurality of different receive gain levels. The mobile wireless communications device may also include a controller configured to select the given receive gain level based upon the given transmit power level of the cellular transceiver.

More specifically, the controller may be configured to select the given receive gain level to be a lower receive gain level based upon the given transmit power level being a higher transmit power level. Also, the controller may be configured to select the given receive gain level to be a higher receive gain level based upon the given transmit power level being a lower transmit power level.

In some embodiments, the controller may be configured to dynamically select the given transmit power level, and dynamically select the given receive gain level. The controller may further comprise a memory configured to store a table of the plurality different transmit power levels and the corresponding plurality of different receive gain levels.

The mobile wireless communications device may further comprise a WLAN antenna coupled to the WLAN transceiver, and the WLAN transceiver may comprise an amplifier coupled downstream from the WLAN antenna. Additionally, the WLAN transceiver may be configured to operate the amplifier based upon the given receive gain level. The WLAN transceiver may comprise at least one mixer downstream from the amplifier, at least one filter downstream from the at least one mixer, and an analog-to-digital converter downstream from the at least one filter. For example, the WLAN transceiver may comprise an IEEE 802.11 transceiver, and the cellular transceiver may comprise at least one of a long term evolution (LTE) transceiver and a WiMAX IEEE 802.16 transceiver.

Another aspect is directed to a method of operating a mobile wireless communications device comprising a cellular transceiver operating at a given transmit power level from among a plurality different transmit power levels, and a WLAN transceiver operating at a given receive gain level from among a plurality of different receive gain levels. The method may include selecting the given receive gain level based upon the given transmit power level of the cellular transceiver.

Example mobile wireless communications devices may include portable or personal media players (e.g., music or MP3 players, video players, etc.), remote controls (e.g., television or stereo remotes, etc.), portable gaming devices, portable or mobile telephones, smartphones, tablet computers, etc.

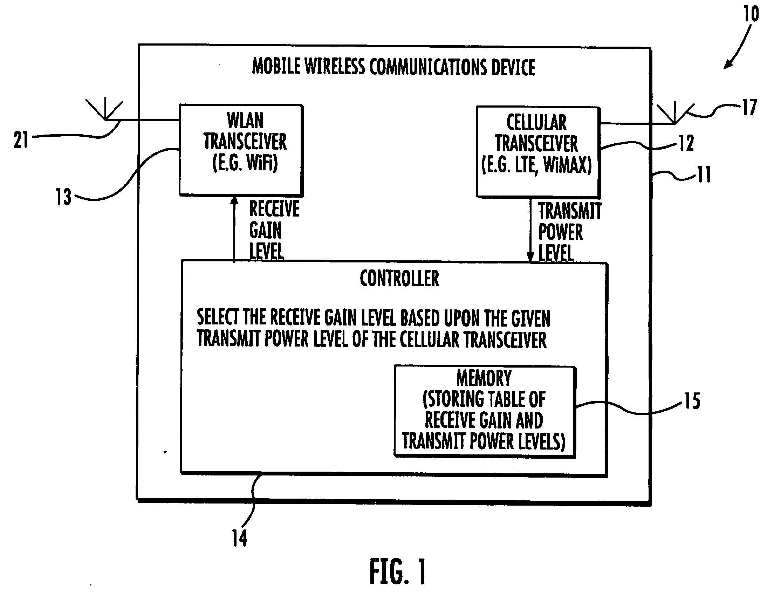

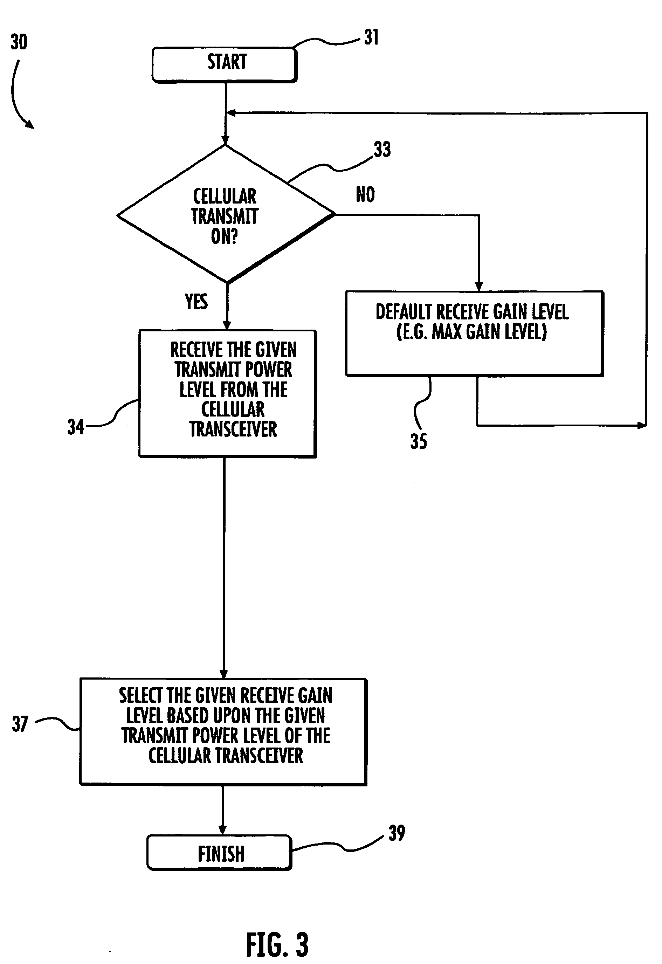

Referring now to FIG. 1, a mobile wireless communications device **10** according to the present disclosure is now described. Moreover, with reference additionally to FIG. 3, a flowchart **30** illustrates a method of operating the mobile wireless communications device **10** (Block **31**). The mobile wireless communications device **10** illustratively includes a housing **11,** and a cellular transceiver **12** carried by the housing and configured to operate at a given transmit power level from among a plurality different transmit power levels. The given transmit power level of the cellular transceiver **12** may be based upon a given cellular standard and directions from the base station.

The mobile wireless communications device **10** illustratively includes a WLAN transceiver **13** carried by the housing **11** and configured to operate at a given receive gain level from among a plurality of different receive gain levels. For example, the WLAN transceiver **13** may comprise an IEEE 802.11 transceiver, and the cellular transceiver **12** may comprise one or more of an LTE transceiver and a WiMAX IEEE 802.16 transceiver. In the illustrated embodiment, the mobile wireless communications device **10** includes a cellular antenna **17** coupled to the cellular transceiver **12**, and a WLAN antenna **21** coupled to the WLAN transceiver **13.**

The mobile wireless communications device **10** illustratively includes a controller **14** configured to select the given receive gain level based upon the given transmit power level of the cellular transceiver. If the cellular transceiver **12** is not transmitting, the controller **14** makes no changes to regular receive gain levels in the WLAN transceiver **13** (Blocks **33, 35**), i.e. purely attempting to maximize WLAN receive signal dynamic range and signal quality. On the other hand, during cellular transmit operations, the controller **14** will adjust receive gain levels to reduce the WLAN desensitization effect from the cellular transceiver **12** (Blocks **34, 37, 39**), i.e. backing off WLAN receive gain levels to attempt to prevent desensitization.

In some embodiments, the controller **14** may be configured to select the given receive gain level to be a lower receive gain level based upon the given transmit power level being a higher transmit power level. In short, the sensitivity of the WLAN transceiver **13** is improved by decreasing the receive gain level thereof. Also, the controller **14** may be configured to select the given receive gain level to be a higher receive gain level based upon the given transmit power level being a lower transmit power level. In advantageous embodiments, the controller **14** may be configured to dynamically select the given transmit power level, and dynamically select the given receive gain level. In the illustrated embodiment, the controller **14** comprises a memory **15** configured to store a table of the plurality different transmit power levels and the corresponding plurality of different receive gain levels. This may cause the controller **14** to better tailor the WLAN receive gain level to the power of the cellular transmission causing the desensitization.

Although in the illustrated embodiment, the disclosed method is used to mitigate interference from the cellular transceiver **12** in the mobile wireless communications device **10,** the method may be applied to self-interference from other transmitters. In other words, the cellular transceiver **12** and the WLAN transceiver **13** may each comprise another type of transceiver.

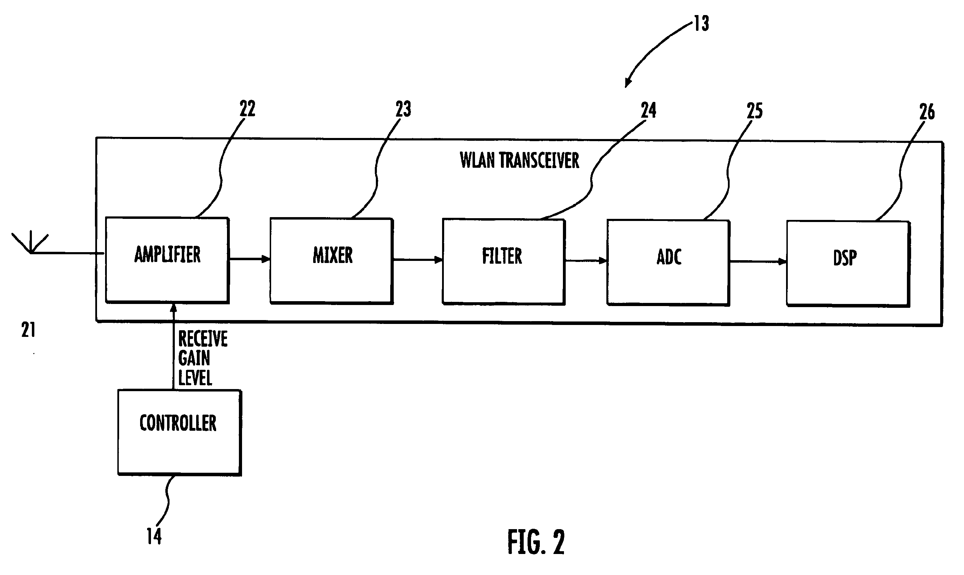

Referring now additionally to FIG. 2, the receiver chain of the WLAN transceiver **13** is shown in detail. The WLAN transceiver comprises an amplifier **22** coupled downstream from the WLAN antenna, a mixer **23** downstream from the amplifier, a filter **24** downstream from the mixer, an analog-to-digital converter (ADC) **25** downstream from the at least one filter, and a digital signal processor **26** downstream from the ADC. Additionally, the WLAN transceiver **13** may be configured to operate the amplifier **22** based upon the given receive gain level.

Another aspect is directed to a method of operating a mobile wireless communications device **10** comprising a cellular transceiver **12** operating at a given transmit power level from among a plurality different transmit power levels, and a WLAN transceiver **13** operating at a given receive gain level from among a plurality of different receive gain levels. The method may include selecting the given receive gain level based upon the given transmit power level of the cellular transceiver **12.**

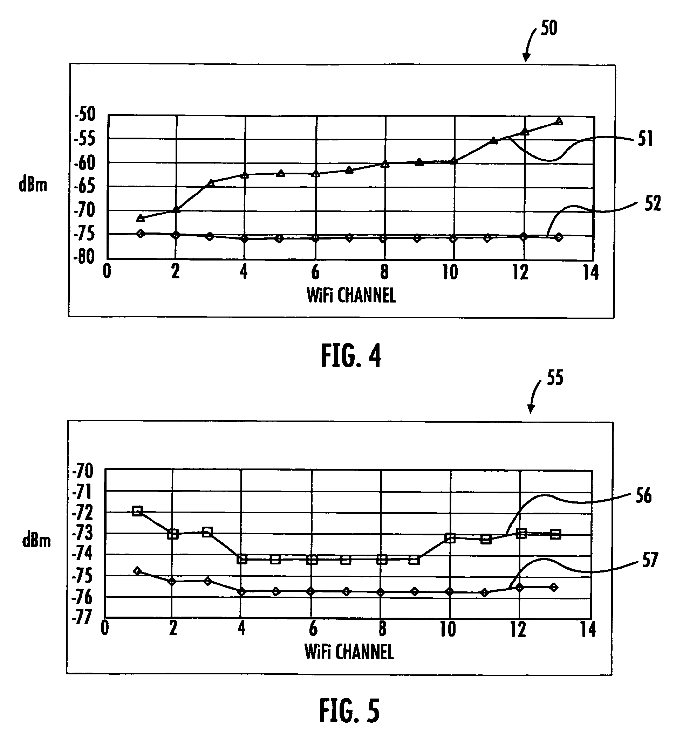

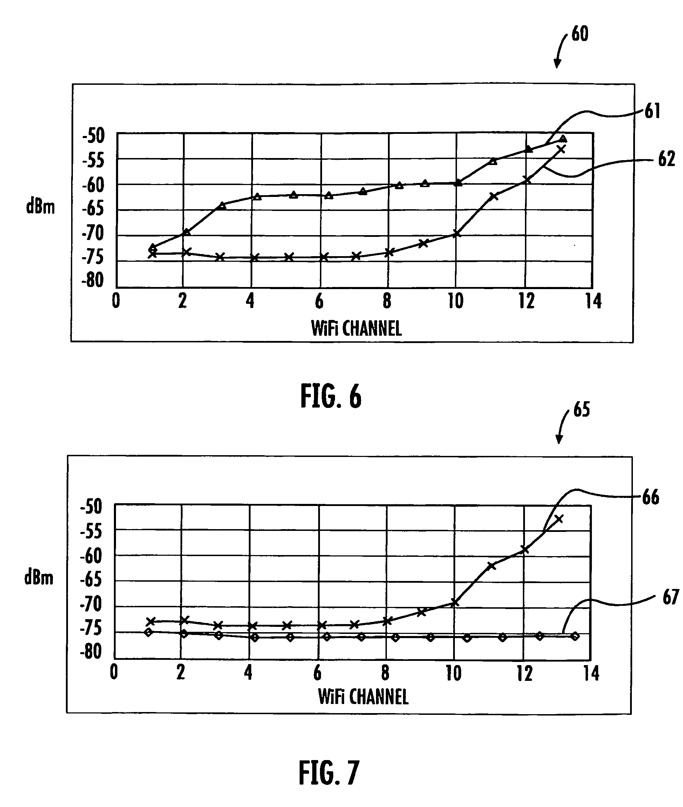

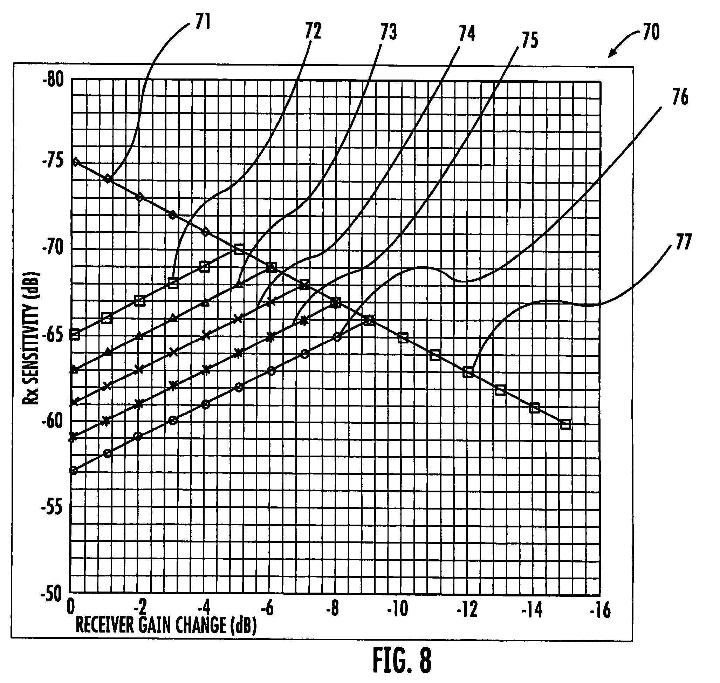

Referring now to FIGS. 4-8, a simulation of performance of an example embodiment of the mobile wireless communications device **10** is now described. It has been observed that in some example implementations, there may be an issue with radiated radio performance. Partially, that is because of self de-sensitization due to limited antenna isolation on a handheld wireless device, such as when the WLAN 802.11b/g receiver (2402-2483 MHz) is de-sensed by the LTE transmitter B7 (2500-2570 MHz). Typically, automatic gain control (AGC) control algorithms are targeted for best receiver sensitivity and dynamic range for in-band signal.

To provide an approach to the issue described above, the herein described method may provide best out-of-band blocking performance of a radio receiver without damaging the receiver in-band sensitivity during the absence of the out-of-band interference. For example, when strong out-of-band interference is detected, the controller **14** may adaptively adjust the receiver chain based on the strength of the out-of-band interfering signal with minimal impact to in-band receiver sensitivity.

For example, a diagram **50** shows WLAN receiver sensitivity data across the frequency band, from Channel (CH) 1 to CH13. Curve **52** shows sensitivity without any blocking signal, and curve **51** shows sensitivity with 20M LTE UL transmitting at 2510MHz. As will be appreciated, the receiver is jammed while LTE radio is transmitting, the sensitivity degraded by about 3 to 23 dBm from CH1 to CH13.

In order to improve the blocking performance of the WLAN receiver, the method disclosed herein intentionally sacrifices the in-band signal sensitivity as shown in diagram **55.** Curves **56** shows the sensitivity without any blocking signal and with the gain table changes while curve **57** shows the sensitivity without any blocking signal and without the gain table changes. The receiver sensitivity with gain table change is about 2-3 dBm worse than that of original gain setting across the frequency band.

Now, in diagram **60,** the sensitivity with (curve **62**) and without (curve **61**) gain table changes is compared, while the LTE blocking signal is present. As will be appreciated, there is an improvement due to the gain table change in comparison with the presence of the out-of-band blocking signal. It should be noted that since this gain table may be permanent, the receiver sensitivity will be degraded by about 3 dBm even without the preset of the out-of-band blocking signal as illustrated also in diagram **60** for those lower channels.

Therefore, to provide an approach to this issue, an adaptive algorithm of the gain table control is disclosed. By detecting the presence of the out-of-band blocking signal, the controller **14** may maintain the best receiver sensitivity and blocking performance no matter the out-of-band blocking signal is there or not.

To understand the method, diagram **65** provides two curves of WLAN sensitivity data across the 2.4 GHz ISM band with 13 channels. Curve **67** is the sensitivity without the gain change and in the absence of the out-of-band blocking signal (which, for example, is the 1st TX channel of LTE Band 7). Curve **66** is the sensitivity with gain table change and in the presence of the blocking signal. When the blocking signal appears, which the controller **14** has pre-knowledge of from the controller of the LTE transceiver, the controller may change the gain table to get better blocking performance, overall sensitivity and data throughput. When the blocking signal is gone, the controller **14** may switch the gain table back to nominal value to achieve the best sensitivity.

Furthermore, during the presence of the out-of-band blocking signal, the blocking signal strength could vary significantly. To achieve the best trade-off of the in-band receiver sensitivity and out-of-band blocking performance, the receiver gain table vs. the blocking signal strength should be properly established. Then, the proper gain table for each blocking signal level could be set, respectively, and the optimal blocking performance for each channel could be achieved.

In diagram **70,** the relationship between the WLAN receiver **13** sensitivity and different blocking signal levels is shown. With a different blocking signal level, there is a different gain change point to achieve the best sensitivity during the presence of the blocking signal.

For example, with the blocking signal strength being at level 5 (curve **76**) it is found that the best blocking performance of -66 dBm sensitivity is achieved by backing off the receiver gain by about 9 dBm. However, with weaker blocking signal strength at level 1 (Curve **72**), a best blocking performance of -70 dBm sensitivity is achieved by backing off the receiver gain by about 5 dBm. If the controller **14** does not change the gain setting and maintains the original back-off gain setting of 9 dBm, the WLAN receiver **13** sensitivity would stay at 66 dBm. Curve **71** shows RX sensitivity without the blocking signal. Curves **72-76** show corresponding RX sensitivity with the blocking signal at power levels 1-5, respectively.

Therefore, based on the analysis of this relationship between the blocking signal level and the receiver gain back-off and the benefit of achieving the optimal receiver sensitivity during the presence of the out-of-band blocking signal, the controller **14** shall adaptively change the gain setting of receiver chain with respect to level of blocking signal strength, to achieve the best overall sensitivity and data throughput in different environments.

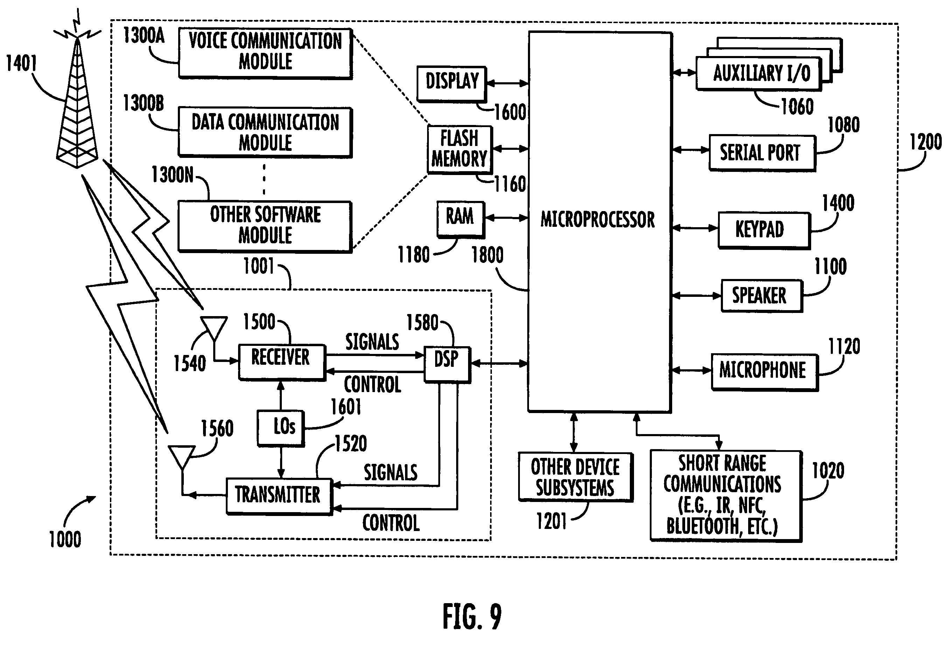

Example components of a mobile wireless communications device **1000** that may be used in accordance with the above-described embodiments are further described below with reference to FIG. 9. The device **1000** illustratively includes a housing **1200,** a keyboard or keypad **1400** and an output device **1600.** The output device shown is a display **1600,** which may comprise a full graphic liquid crystal display (LCD). Other types of output devices may alternatively be utilized. A processing device **1800** is contained within the housing **1200** and is coupled between the keypad **1400** and the display **1600.** The processing device **1800** controls the operation of the display **1600,** as well as the overall operation of the mobile device **1000,** in response to actuation of keys on the keypad **1400.**

The housing **1200** may be elongated vertically, or may take on other sizes and shapes (including clamshell housing structures). The keypad may include a mode selection key, or other hardware or software for switching between text entry and telephony entry.

In addition to the processing device **1800,** other parts of the mobile device **1000** are shown schematically in FIG. 9. These include a communications subsystem **1001;** a short-range communications subsystem **1020;** the keypad **1400** and the display **1600,** along with other input/output devices **1060, 1080, 1100** and **1120;** as well as memory devices **1160, 1180** and various other device subsystems **1201.** The mobile device **1000** may comprise a two-way RF communications device having data and, optionally, voice communications capabilities. In addition, the mobile device **1000** may have the capability to communicate with other computer systems via the Internet.

Operating system software executed by the processing device **1800** is stored in a persistent store, such as the flash memory **1160,** but may be stored in other types of memory devices, such as a read only memory (ROM) or similar storage element. In addition, system software, specific device applications, or parts thereof, may be temporarily loaded into a volatile store, such as the random access memory (RAM) **1180.** Communications signals received by the mobile device may also be stored in the RAM **1180.**

The processing device **1800,** in addition to its operating system functions, enables execution of software applications **1300A-1300N** on the device **1000.** A predetermined set of applications that control basic device operations, such as data and voice communications **1300A** and **1300B,** may be installed on the device **1000** during manufacture. In addition, a personal information manager (PIM) application may be installed during manufacture. The PIM may be capable of organizing and managing data items, such as e-mail, calendar events, voice mails, appointments, and task items. The PIM application may also be capable of sending and receiving data items via a wireless network **1401.** The PIM data items may be seamlessly integrated, synchronized and updated via the wireless network **1401** with corresponding data items stored or associated with a host computer system.

Communication functions, including data and voice communications, are performed through the communications subsystem **1001,** and possibly through the short-range communications subsystem **1020.** The communications subsystem **1001** includes a receiver **1500,** a transmitter **1520,** and one or more antennas **1540** and **1560.** In addition, the communications subsystem **1001** also includes a processing module, such as a digital signal processor (DSP) **1580,** and local oscillators (LOs) **1601.** The specific design and implementation of the communications subsystem **1001** is dependent upon the communications network in which the mobile device **1000** is intended to operate. For example, a mobile device **1000** may include a communications subsystem **1001** designed to operate with the Mobitex™, Data TAC™ or General Packet Radio Service (GPRS) mobile data communications networks, and also designed to operate with any of a variety of voice communications networks, such as Advanced Mobile Phone System (AMPS), time division multiple access (TDMA), code division multiple access (CDMA), Wideband code division multiple access (W-CDMA), personal communications service (PCS), GSM (Global System for Mobile Communications), enhanced data rates for GSM evolution (EDGE), etc. Other types of data and voice networks, both separate and integrated, may also be utilized with the mobile device **1000.** The mobile device **1000** may also be compliant with other communications standards such as 3GSM, 3rd Generation Partnership Project (3GPP), Universal Mobile Telecommunications System (UMTS), 4G, etc.

Network access requirements vary depending upon the type of communication system. For example, in the Mobitex and DataTAC networks, mobile devices are registered on the network using a unique personal identification number or PIN associated with each device. In GPRS networks, however, network access is associated with a subscriber or user of a device. A GPRS device therefore typically involves use of a subscriber identity module, commonly referred to as a SIM card, in order to operate on a GPRS network.

When required network registration or activation procedures have been completed, the mobile device **1000** may send and receive communications signals over the communication network **1401.** Signals received from the communications network **1401** by the antenna **1540** are routed to the receiver **1500,** which provides for signal amplification, frequency down conversion, filtering, channel selection, etc., and may also provide analog to digital conversion. Analog-to-digital conversion of the received signal allows the DSP **1580** to perform more complex communications functions, such as demodulation and decoding. In a similar manner, signals to be transmitted to the network **1401** are processed (e.g. modulated and encoded) by the DSP **1580** and are then provided to the transmitter **1520** for digital to analog conversion, frequency up conversion, filtering, amplification and transmission to the communication network **1401** (or networks) via the antenna **1560.**

In addition to processing communications signals, the DSP **1580** provides for control of the receiver **1500** and the transmitter **1520.** For example, gains applied to communications signals in the receiver **1500** and transmitter **1520** may be adaptively controlled through automatic gain control algorithms implemented in the DSP **1580.**

In a data communications mode, a received signal, such as a text message or web page download, is processed by the communications subsystem **1001** and is input to the processing device **1800.** The received signal is then further processed by the processing device **1800** for an output to the display **1600,** or alternatively to some other auxiliary I/O device **1060.** A device may also be used to compose data items, such as e-mail messages, using the keypad **1400** and/or some other auxiliary I/O device **1060,** such as a touchpad, a rocker switch, a thumb-wheel, or some other type of input device. The composed data items may then be transmitted over the communications network **1401** via the communications subsystem **1001.**

In a voice communications mode, overall operation of the device is substantially similar to the data communications mode, except that received signals are output to a speaker **1100,** and signals for transmission are generated by a microphone **1120.** Alternative voice or audio I/O subsystems, such as a voice message recording subsystem, may also be implemented on the device **1000.** In addition, the display **1600** may also be utilized in voice communications mode, for example to display the identity of a calling party, the duration of a voice call, or other voice call related information.

The short-range communications subsystem enables communication between the mobile device **1000** and other proximate systems or devices, which need not necessarily be similar devices. For example, the short-range communications subsystem may include an infrared device and associated circuits and components, a Bluetooth™ communications module to provide for communication with similarly-enabled systems and devices, or a NFC sensor for communicating with a NFC device or NFC tag via NFC communications.

Many modifications and other embodiments will come to the mind of one skilled in the art having the benefit of the teachings presented in the foregoing descriptions and the associated drawings. Therefore, it is understood that various modifications and embodiments are intended to be included within the scope of the appended claims.

## Claims

1. A mobile wireless communications device (10) comprising:
a housing (11);
a cellular transceiver (12) carried by said housing and configured to operate at a given transmit power level from among a plurality of different transmit power levels;
a wireless local area network (WLAN) transceiver (13) carried by said housing and configured to operate at a given receive gain level from among a plurality of different receive gain levels; and
a controller (14) configured to receive the given transmit power level of said cellular transceiver, and select the given receive gain level based upon the given transmit power level of said cellular transceiver, said cellular transceiver (12) and said WLAN transceiver (14) being internal to said housing (11).

2. The mobile wireless communications device of Claim 1 wherein said controller is configured to select the given receive gain level to be a lower receive gain level based upon the given transmit power level being a higher transmit power level.

3. The mobile wireless communications device of Claim 1 wherein said controller is configured to select the given receive gain level to be a higher receive gain level based upon the given transmit power level being a lower transmit power level.

4. The mobile wireless communications device of Claim 1 wherein said controller is configured to dynamically select the given transmit power level, and dynamically select the given receive gain level.

5. The mobile wireless communications device of Claim 1 wherein said controller further comprises a memory (15) configured to store a table of the plurality of different transmit power levels and the corresponding plurality of different receive gain levels.

6. The mobile wireless communications device of Claim 1 further comprising a WLAN antenna (21) coupled to said WLAN transceiver; and wherein said WLAN transceiver comprises an amplifier (22) coupled downstream from said WLAN antenna.

7. The mobile wireless communications device of Claim 6 wherein said WLAN transceiver is configured to operate said amplifier based upon the given receive gain level.

8. The mobile wireless communications device of Claim 6 wherein said WLAN transceiver comprises at least one mixer (23) downstream from said amplifier, at least one filter (24) downstream from said at least one mixer, and an analog-to-digital converter (25) downstream from said at least one filter.

9. The mobile wireless communications device of Claim 1 wherein said WLAN transceiver comprises an IEEE 802.11 transceiver; and wherein said cellular transceiver comprises at least one of a long term evolution (LTE) transceiver and a WiMAX IEEE 802.16 transceiver.

10. A method of operating a mobile wireless communications device comprising a cellular transceiver (12) operating at a given transmit power level from among a plurality of different transmit power levels, and a wireless local area network (WLAN) transceiver (13) operating at a given receive gain level from among a plurality of different receive gain levels, the method comprising:
receiving the given transmit power level of said cellular transceiver, and selecting the given receive gain level based upon the given transmit power level of the cellular transceiver, the cellular transceiver (12) and the WLAN transceiver (14) being internal to said housing (11).

11. The method of Claim 10 further comprising selecting the given receive gain level to be a lower receive gain level based upon the given transmit power level being a higher transmit power level.

12. The method of Claim 10 further comprising selecting the given receive gain level to be a higher receive gain level based upon the given transmit power level being a lower transmit power level.

13. The method of Claim 10 further comprising dynamically selecting the given transmit power level, and dynamically selecting the given receive gain level.

14. The method of Claim 10 further comprising storing a table of the plurality of different transmit power levels and the corresponding plurality of different receive gain levels in a memory of the mobile wireless communications device.

15. The method of Claim 10 further comprising a WLAN antenna (21) coupled to the WLAN transceiver; and wherein the WLAN transceiver comprises an amplifier (22) coupled downstream from the WLAN antenna.

## Patentansprüche

1. Eine mobile drahtlose Kommunikationsvorrichtung (10), die aufweist:
ein Gehäuse (11);
einen zellularen Transceiver (12), der durch das Gehäuse getragen wird und konfiguriert ist für einen Betrieb bei einem gegebenen Sendeleistungspegel aus einer Vielzahl von verschiedenen Sendeleistungspegeln;
einen "drahtloses lokales Netzwerk (WLAN - wireless local area network)"-Transceiver (13), der durch das Gehäuse getragen wird und konfiguriert ist für einen Betrieb bei einem gegebenen Empfangsverstärkungspegel aus einer Vielzahl von verschiedenen Empfangsverstärkungspegeln; und
eine Steuervorrichtung (14), die konfiguriert ist zum Empfangen des gegebenen Sendeleistungspegels des zellularen Transceivers und Auswählen des gegebenen Empfangsverstärkungspegels basierend auf dem gegebenen Sendeleistungspegel des zellularen Transceivers, wobei der zellulare Transceiver (12) und der WLAN-Transceiver (14) intern in dem Gehäuse (11) sind.

2. Die mobile drahtlose Kommunikationsvorrichtung gemäß Anspruch 1, wobei die Steuervorrichtung konfiguriert ist zum Auswählen, dass der gegebene Empfangsverstärkungspegel ein niedrigerer Empfangsverstärkungspegel ist, basierend darauf, dass der gegebene Sendeleistungspegel ein höherer Sendeleistungspegel ist.

3. Die mobile drahtlose Kommunikationsvorrichtung gemäß Anspruch 1, wobei die Steuervorrichtung konfiguriert ist zum Auswählen, dass der gegebene Empfangsverstärkungspegel ein höherer Empfangsverstärkungspegel ist, basierend darauf, dass der gegebene Sendeleistungspegel ein niedrigerer Sendeleistungspegel ist.

4. Die mobile drahtlose Kommunikationsvorrichtung gemäß Anspruch 1, wobei die Steuervorrichtung konfiguriert ist zum dynamischen Auswählen des gegebenen Sendeleistungspegels und zum dynamischen Auswählen des gegebenen Empfangsverstärkungspegels.

5. Die mobile drahtlose Kommunikationsvorrichtung gemäß Anspruch 1, wobei der Steuervorrichtung weiter einen Speicher (15) aufweist, der konfiguriert ist zum Speichern einer Tabelle der Vielzahl von verschiedenen Sendeleistungspegeln und der entsprechenden Vielzahl von verschiedenen Empfangsverstärkungspegeln.

6. Die mobile drahtlose Kommunikationsvorrichtung gemäß Anspruch 1, die weiter eine WLAN-Antenne (21) aufweist, die mit dem WLAN-Transceiver gekoppelt ist; und wobei der WLAN-Transceiver einen Verstärker (22) aufweist, der stromabwärts von der WLAN-Antenne gekoppelt ist.

7. Die mobile drahtlose Kommunikationsvorrichtung gemäß Anspruch 6, wobei der WLAN-Transceiver konfiguriert ist für einen Betrieb des Verstärkers basierend auf dem gegebenen Empfangsverstärkungspegel.

8. Die mobile drahtlose Kommunikationsvorrichtung gemäß Anspruch 6, wobei der WLAN-Transceiver zumindest einen Mischer (23) stromabwärts von dem Verstärker, zumindest einen Filter (24) stromabwärts von dem zumindest einen Mischer und einen Analog-Digital-Wandler (25) stromabwärts von dem zumindest einen Filter aufweist.

9. Die mobile drahtlose Kommunikationsvorrichtung gemäß Anspruch 1, wobei der WLAN-Transceiver einen IEEE 802.11-Transceiver aufweist; und wobei der zellulare Transceiver zumindest einen aus einem LTE(Long Term Evolution)-Transceiver und einem WiMAX-IEEE 802.16-Transceiver aufweist.

10. Ein Verfahren für einen Betrieb einer mobilen drahtlosen Kommunikationsvorrichtung, die einen zellularen Transceiver (12), der bei einem gegebenen Sendeleistungspegel aus einer Vielzahl von verschiedenen Sendeleistungspegeln arbeitet, und einen "drahtloses lokales Netzwerk (WLAN - wireless local area network)"-Transceiver (13) aufweist, der bei einem gegebenen Empfangsverstärkungspegel aus einer Vielzahl von verschiedenen Empfangsverstärkungspegeln arbeitet, wobei das Verfahren aufweist:
Empfangen des gegebenen Sendeleistungspegels des zellularen Transceivers und Auswählen des gegebenen Empfangsverstärkungspegels basierend auf dem gegebenen Sendeleistungspegel des zellularen Transceivers, wobei der zellulare Transceiver (12) und der WLAN-Transceiver (14) intern in dem Gehäuse (11) sind.

11. Das Verfahren gemäß Anspruch 10, das weiter aufweist ein Auswählen, dass der gegebene Empfangsverstärkungspegel ein niedrigerer Empfangsverstärkungspegel ist, basierend darauf, dass der gegebene Sendeleistungspegel ein höherer Sendeleistungspegel ist.

12. Das Verfahren gemäß Anspruch 10, das weiter aufweist ein Auswählen, dass der gegebene Empfangsverstärkungspegel ein höherer Empfangsverstärkungspegel ist, basierend darauf, dass der gegebene Sendeleistungspegel ein niedrigerer Sendeleistungspegel ist.

13. Das Verfahren gemäß Anspruch 10, das weiter ein dynamisches Auswählen des gegebenen Sendeleistungspegels und ein dynamisches Auswählen des gegebenen Empfangsverstärkungspegels aufweist.

14. Das Verfahren gemäß Anspruch 10, das weiter aufweist ein Speichern einer Tabelle der Vielzahl von verschiedenen Sendeleistungspegeln und der entsprechenden Vielzahl von verschiedenen Empfangsverstärkungspegeln in einem Speicher der mobilen drahtlosen Kommunikationsvorrichtung.

15. Das Verfahren gemäß Anspruch 10, das weiter eine WLAN-Antenne (21) aufweist, die mit dem WLAN-Transceiver gekoppelt ist; und wobei der WLAN-Transceiver einen Verstärker (22) aufweist, der stromabwärts von der WLAN-Antenne gekoppelt ist.

## Revendications

1. Dispositif de communication mobile sans fil (10), comprenant :
un boîtier (11) ;
un émetteur-récepteur cellulaire (12) porté par ledit boîtier et configuré pour fonctionner à un niveau de puissance d'émission donné parmi une pluralité de différents niveaux de puissance d'émission ;
un émetteur-récepteur de réseau local sans fil, WLAN pour « Wireless Local Area Network », (13) porté par ledit boîtier et configuré pour fonctionner à un niveau de gain de réception donné parmi une pluralité de différents niveaux de gain de réception ; et
un contrôleur (14) configuré pour recevoir le niveau de puissance d'émission donné dudit émetteur-récepteur cellulaire, et pour sélectionner le niveau de gain de réception donné en fonction du niveau de puissance d'émission donné dudit émetteur-récepteur cellulaire, ledit émetteur-récepteur cellulaire (12) et ledit émetteur-récepteur WLAN (13) étant situés à l'intérieur dudit boîtier (11).

2. Dispositif de communication mobile sans fil selon la revendication 1, dans lequel ledit contrôleur est configuré pour sélectionner, pour le niveau de gain de réception donné, un niveau de gain de réception inférieur en se fondant sur le fait que le niveau de puissance d'émission donné est un niveau de puissance d'émission supérieur.

3. Dispositif de communication mobile sans fil selon la revendication 1, dans lequel ledit contrôleur est configuré pour sélectionner, pour le niveau de gain de réception donné, un niveau de gain de réception supérieur en se fondant sur le fait que le niveau de puissance d'émission donné est un niveau de puissance d'émission inférieur.

4. Dispositif de communication mobile sans fil selon la revendication 1, dans lequel ledit contrôleur est configuré pour sélectionner dynamiquement le niveau de puissance d'émission donné et pour sélectionner dynamiquement le niveau de gain de réception donné.

5. Dispositif de communication mobile sans fil selon la revendication 1, dans lequel ledit contrôleur comprend en outre une mémoire (15) configurée pour enregistrer une table constituée de la pluralité de différents niveaux de puissance d'émission et de la pluralité correspondante de différents niveaux de gain de réception.

6. Dispositif de communication mobile sans fil selon la revendication 1, comprenant en outre une antenne WLAN (21) couplée audit émetteur-récepteur WLAN ; et dans lequel ledit émetteur-récepteur WLAN comprend un amplificateur (22) couplé en aval de ladite antenne WLAN.

7. Dispositif de communication mobile sans fil selon la revendication 6, dans lequel ledit émetteur-récepteur WLAN est configuré pour faire fonctionner ledit amplificateur en fonction du niveau de gain de réception donné.

8. Dispositif de communication mobile sans fil selon la revendication 6, dans lequel ledit émetteur-récepteur WLAN comprend au moins un mélangeur (23) en aval dudit amplificateur, au moins un filtre (24) en aval dudit au moins un mélangeur, et un convertisseur analogique-numérique (25) en aval dudit au moins un filtre.

9. Dispositif de communication mobile sans fil selon la revendication 1, dans lequel ledit émetteur-récepteur WLAN consiste en un émetteur-récepteur IEEE 802.11 ; et dans lequel ledit émetteur-récepteur cellulaire consiste en au moins soit un émetteur-récepteur pour l'évolution à long terme, LTE pour « *Long Terme Evolution* », soit un émetteur-récepteur WiMAX IEEE 802.16.

10. Procédé de fonctionnement d'un dispositif de communication mobile sans fil comprenant un émetteur-récepteur cellulaire (12) fonctionnant à un niveau de puissance d'émission donné parmi une pluralité de différents niveaux de puissance d'émission, et un émetteur-récepteur de réseau local sans fil, WLAN pour « Wireless Local Area Network », (13) fonctionnant à un niveau de gain de réception donné parmi une pluralité de différents niveaux de gain de réception, le procédé comprenant les étapes consistant à :
recevoir le niveau de puissance d'émission donné dudit émetteur-récepteur cellulaire, et sélectionner le niveau de gain de réception donné en fonction du niveau de puissance d'émission donné de l'émetteur-récepteur cellulaire, l'émetteur-récepteur cellulaire (12) et l'émetteur-récepteur WLAN (13) étant situés à l'intérieur dudit boîtier (11).

11. Procédé selon la revendication 10, comprenant en outre l'étape consistant à sélectionner, pour le niveau de gain de réception donné, un niveau de gain de réception inférieur en se fondant sur le fait que le niveau de puissance d'émission donné est un niveau de puissance d'émission supérieur.

12. Procédé selon la revendication 10, comprenant en outre l'étape consistant à sélectionner, pour le niveau de gain de réception donné, un niveau de gain de réception supérieur en se fondant sur le fait que le niveau de puissance d'émission donné est un niveau de puissance d'émission inférieur.

13. Procédé selon la revendication 10, comprenant en outre les étapes consistant à sélectionner dynamiquement le niveau de puissance d'émission donné, et à sélectionner dynamiquement le niveau de gain de réception donné.

14. Procédé selon la revendication 10, comprenant en outre l'étape consistant à enregistrer une table constituée de la pluralité de différents niveaux de puissance d'émission et de la pluralité correspondante de différents niveaux de gain de réception dans une mémoire du dispositif de communication mobile sans fil.

15. Procédé selon la revendication 10, comprenant en outre une antenne WLAN (21) couplée à l'émetteur-récepteur WLAN, et dans lequel l'émetteur-récepteur WLAN comprend un amplificateur (22) couplé en aval de l'antenne WLAN.
